Europäisches Patentamt

**European Patent Office**

**Office européen des brevets**

(11) Publication number: **0 038 652**
**A2**

## (12) EUROPEAN PATENT APPLICATION

(21) Application number: **81301569.0**

(22) Date of filing: **10.04.81**

(51) Int. Cl.³: **H 05 K 5/00**
**H 02 B 1/08, G 12 B 9/02**

(30) Priority: **21.04.80 GB 8012990**

(43) Date of publication of application:
**28.10.81 Bulletin 81/43**

(84) Designated Contracting States:
**AT BE CH DE FR IT LI LU NL SE**

(71) Applicant: **VERO ELECTRONICS LIMITED**
**Industrial Estate Chandler's Ford**
**Eastleigh Hampshire S05 3ZR(GB)**

(72) Inventor: **Quarrell, Graham George**
**8 Meon Road**
**Romsey Hampshire(GB)**

(74) Representative: **Leistikow, Frederick Walter**
**Rudolph et al,**
**BREWER & SON 5-9 Quality Court Chancery Lane**
**London WC2A 1HT(GB)**

(54) **Electrical bonding of metal components.**

(57) Electrical bonding at a joint between components made of anodised aluminium alloy by a serrated steel pin driven in to pierce the protective coating on the components and make contact with the parent metal.

Fig. 2.

EP 0 038 652 A2

-1-

## ELECTRICAL BONDING OF METAL COMPONENTS.

In order to achieve electrical safety with assemblies mounting electrical equipment is is necessary to ensure complete electrical conductivity between the electrically conductive components of the assembly, in particular at the structure joints of the assembly.

A case in point is a rack for accommodating circuit boards of the kind described in our British Patent Application No.2035703A, published 18th June 1980. The components of such a rack are made of metal having a protective surface coating, normally anodised aluminium alloy, and since face-to-face contact between components at the joints is relied on for earthing the anodised finish may detrimentally affect electrical conductivity between the components.

With a view to overcoming this difficulty, the present invention provides an assembly for mounting electrical equipment and including components made of metal having a protective surface coating and joined together in face-to-face contact, said assembly including, at at least one joint between said components and for the purpose of ensuring effective electrical bonding of the components at the joint notwithstanding such protective coating, a pin of harder metal than the components, the pin having a roughened surface devoid of an external insulating layer and being disposed at the joint with its roughened portion making contact with the parent metal of each of said components beneath the protective coating thereon.

The pin is preferably made of steel but may, alternatively, be of hard brass. Its roughened surface may be provided by external grooves or serrations.

The invention will now be further explained with reference to the accompanying drawings, in which :

Fig. 1 is a perspective view of part of a rack for accommodating circuit boards,

Fig. 2 is an exploded view illustrating application of the invention to a joint in the rack shown in Fig. 1, and

Fig. 3 is a view corresponding to Fig. 2 but showing the completed joint.

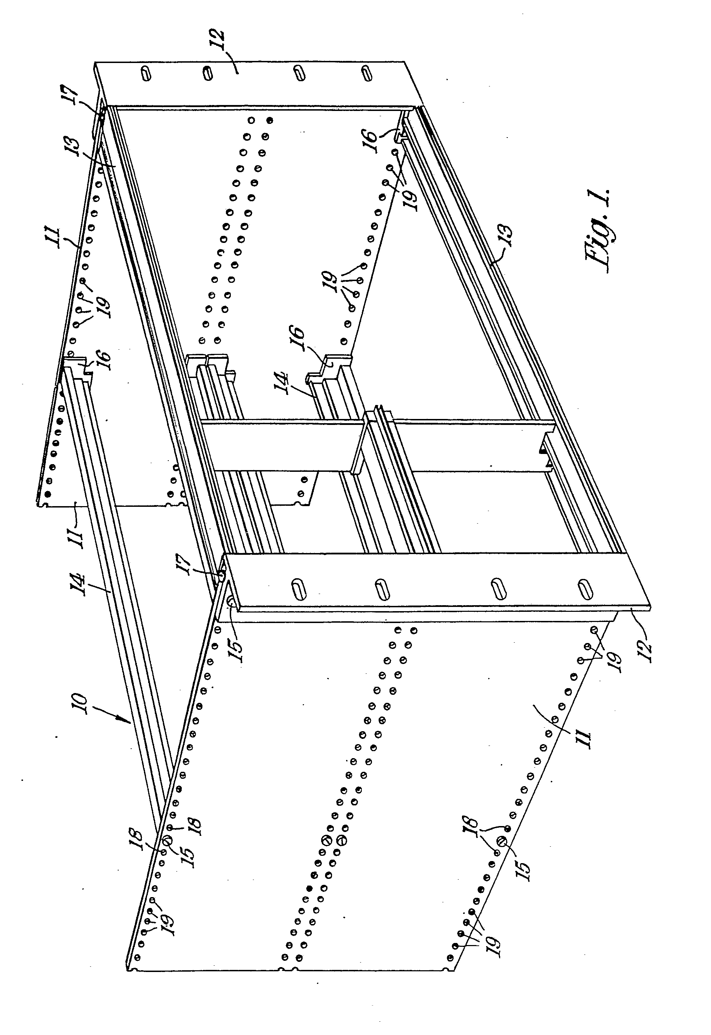

The rack 10 shown in Fig. 1 includes a pair of end plates 11, a pair of angle plates 12 and pairs of front and rear tie bars 13, 14 all of which are made of anodised aluminium alloy. The front and rear tie bars 13, 14 are spanned in the completed rack by opposed pairs of guide rails (not shown) which are moulded from plastics material and are formed with slots in their opposing faces to enable circuit boards to be slid into the rack from the front.

The rear tie bars 14 are joined to the end plates and the front tie bars 13 are joined both to the end plates 11 and to the angle plates 12 by screws 15, locating mouldings 16 of plastics material being provided between the ends of the tie bars and the end plates.

The rack, as so far described, is identical with that described in the aforesaid British Patent Application No.2035703A. As will be appreciated, electrical conductivity between the components at the joints established by the screws 15 depends on face contact between the end plates 11 and the angle plates 12 and the screws establishing contact between the end plates 11 and the tie bars. For the reasons given above the resulting electrical bonding at the joints may be insufficiently effective.

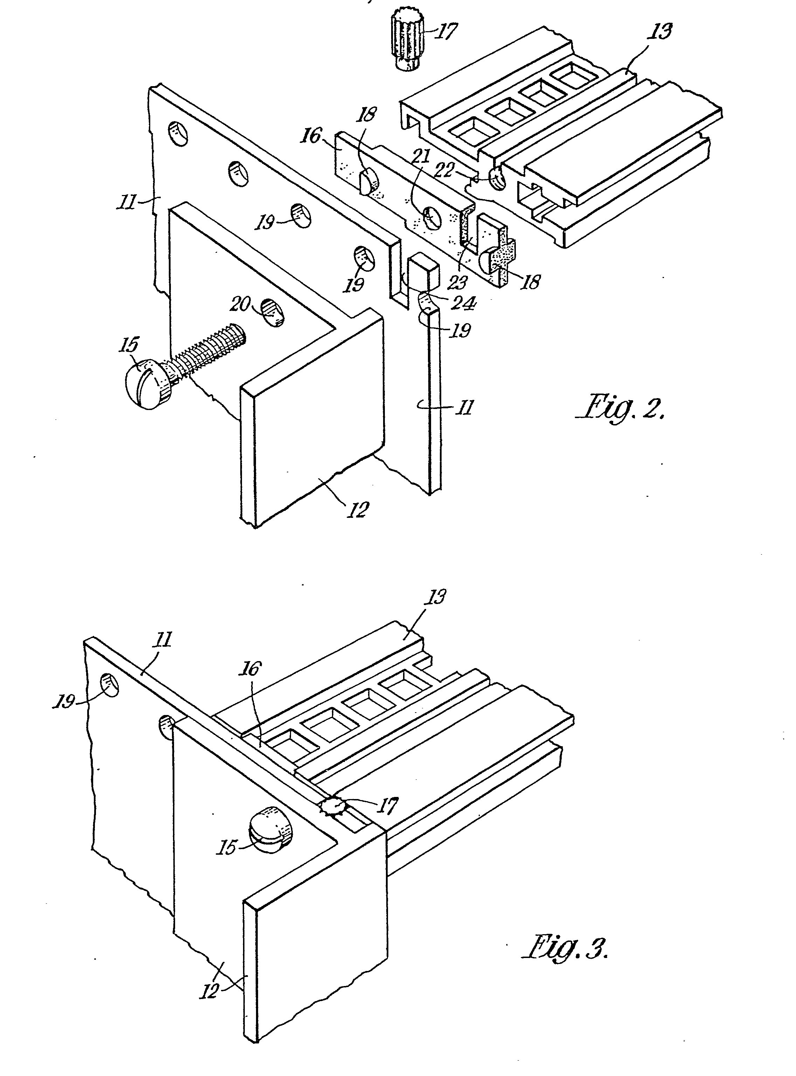

The invention renders the electrical bonding thoroughly reliable by the provision at each such joint of a serrated steel bonding pin 17, as will now be described for the case of the joints at the ends of the front tie bars 13 with reference to Figs. 2 and 3.

As will be seen from Fig. 2, the moulding 16 has locating projections 18 which fit into holes 19 in the adjoining end plate 11 and the screw 15 passes through a hole 20 in the angle plate 12, one of the holes 19 and a hole 21 in the moulding 16 into a tapped hole 22 in the tie bar 13, as in the rack described in the aforesaid British Patent Application.

However, according to the invention, the component 11 is provided with a slot 24 and the moulding 16 with a slot 23 into which the pin 17 is driven as shown in Fig. 3. The pin 17 is of sufficient size to bite into the metal of all three components 11, 12 and 13 and so ensure electrical bonding of the high quality required by recent legislation concerning health and safety at work in respect of equipment for hospitals and in similar areas.

Similar pins 17 are provided at the joints at
the ends of the rear tie bars 14 to ensure electrical
bonding between these tie bars and the end plates 11.
In this case each pin 17 will be driven into a slot
in the moulding 16 and bite into the metal of the
components 11 and 14. Should no mouldings 16 be
required, it will be sufficient to provide grooves
in the facing surfaces of the components 11 and 14 to
receive the pin 17.

CLAIMS:

1.    An assembly for mounting electrical equipment
and including components made of metal having a
protective surface coating and joined together in
face-to-fact contact, said assembly including, at
at least one joint between said components and for
the purpose of ensuring effective electrical bonding
of the components at the joint notwithstanding each
protective coating, a pin of harder metal than the
components, the pin having a roughened surface
devoid of an external insulating layer and being
disposed at the joint with its roughened portion
making contact with the parent metal of each of said
components beneath the protective coating thereon.

2.    An assembly according to claim 1, in which the
pin is a serrated metal pin.

3.    An assembly according to claim 1, in which said
components include  end plates and tie bars extending between the end plates and joined to the end
plates by screws passed through holes in the end
plates into tapped  holes in the tie bars and in
which each joint between said components is electrically bonded by a roughened pin establishing metal-
to-metal contact between the end plates and the tie
bars.

4.    An assembly according to claim 1, substantially
as described herein with reference to the accompany-
ing drawings.

Fig. 1.

*Fig. 2.*

*Fig. 3.*